# EUROPÄISCHE PATENTSCHRIFT

(11) **EP 1 668 674 B1**
(45) Veröffentlichungstag und Bekanntmachung des Hinweises auf die Patenterteilung: **22.05.2013**
(21) Anmeldenummer: 04786174.5
(22) Anmeldetag: 24.08.2004
(51) Int. Cl.: H01L 21/00

(54) **STRAHLUNGSDETEKTOR**
RADIATION DETECTOR
DETECTEUR DE RAYONNEMENT

(30) Priorität: 30.09.2003 DE 10345410
(43) Veröffentlichungstag der Anmeldung: 14.06.2006
(73) Patentinhaber: OSRAM Opto Semiconductors GmbH, 93055 Regensburg (DE)
(72) Erfinder: HAAS, Heinz, 93059 Regensburg (DE); MÖLLMER, Frank, 93080 Matting b. Pentling (DE); SCHWIND, Michael, 93161 Sinzing (DE)
(74) Vertreter: Epping - Hermann - Fischer
(86) Internationale Anmeldenummer: PCT/DE2004/001877
(87) Internationale Veröffentlichungsnummer: WO 2005/041247

(56) Entgegenhaltungen:
- JP-A- 2000 252 482
- JP-A- 2003 258 292
- US-A- 3 903 413
- US-A- 5 600 157
- US-A1- 2003 222 264
- US-B1- 6 476 374
- KARRER UWE ET AL: "AlGaN-based ultraviolet light detectors with integrated optical filters" JOURNAL OF VACUUM SCIENCE & TECHNOLOGY B: MICROELECTRONICS PROCESSING AND PHENOMENA, AMERICAN VACUUM SOCIETY, NEW YORK, NY, US, Bd. 18, Nr. 2, März 2000 (2000-03), Seiten 757-760, XP012008116 ISSN: 0734-211X
- PATENT ABSTRACTS OF JAPAN Bd. 2003, Nr. 09, 3. September 2003 (2003-09-03) -& JP 2003 150089 A (MASPRO DENKOH CORP), 21. Mai 2003 (2003-05-21)
- PATENT ABSTRACTS OF JAPAN Bd. 2002, Nr. 03, 3. April 2002 (2002-04-03) -& JP 2001 308351 A (TOSHIBA CORP), 2. November 2001 (2001-11-02)
- 'InGaAlP-High Brightness Light Emitting Diode', [Online] 08 April 2003, Gefunden im Internet: <URL:http://www.datasheetarchive.com/osram+ topled-datasheet.html> [gefunden am 2012-04-05]

## Beschreibung

Die Erfindung betrifft einen Strahlungsdetektor, der mindestens einen Halbleiterchip umfasst.

Zur Detektion von Strahlung mit einer vorgegebenen spektralen Empfindlichkeitsverteilung, die ein Maximum bei einer vorgegebenen Wellenlänge λ₀ aufweist, werden oftmals Strahlungsdetektoren mit einer speziell angepaßten Filteranordnung, wie beispielsweise Interferenzfiltern oder Monochromatoren verwendet. Derartige Detektoren zeichnen sich durch eine sehr gute Anpassung an die vorgegebene spektrale Empfindlichkeitsverteilung aus, sind aber in ihrer Handhabung und Herstellung meist vergleichsweise aufwendig und kostenintensiv. Weiterhin haben sie oftmals einen hohen Platzbedarf, so dass sie für Anwendungen auf kleinem Raum nicht oder nur eingeschränkt benutzt werden können.

Ist die vorgegebene spektrale Empfindlichkeitsverteilung die des menschlichen Auges, so wird zur Detektion einfallender Strahlung mit dieser Empfindlichkeit häufig eine Silizium-Photodiode benutzt. Für Silizium-Photodioden ist ein geeignetes Filtermaterial in JP 2000-252482 A beschrieben.

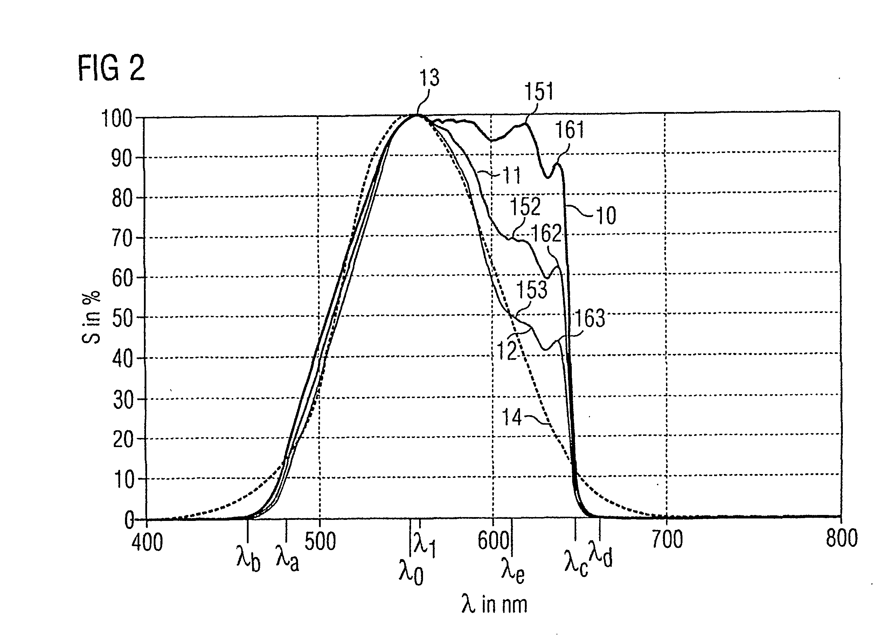

In Teilbereichen des sichtbaren Spektralbereichs weisen auch LEDs, wenn sie als Strahlungsempfänger betrieben werden, eine signifikante Empfindlichkeit auf, wie in Figur 2 der Druckschrift JP 2003-258292 A zu erkennen ist.

Die Empfindlichkeit einer Photodiode hängt unter anderem von den Wellenlängen der einfallenden Strahlung ab. Für Wellenlängen, die größer als eine Grenzwellenlänge sind, ist die Empfindlichkeit zumindest nahe null, da für einfallende Strahlung in diesem Wellenlängenbereich die Energielücke des Funktionsmaterials der Diode - beispielsweise Si - größer als die Energie der einfallenden Strahlung ist und diese somit nicht für die Erzeugung von Elektron-Loch-Paaren ausreicht. Andererseits nimmt die Empfindlichkeit im Bereich kleiner werdender Wellenlängen ab, da mit sinkender Wellenlänge die erzeugten Elektron-Loch-Paare beispielsweise wegen der Oberflächenrekombination vermehrt nicht mehr zum Photostrom beitragen. Im Zwischenbereich weist die Empfindlichkeit der Diode ein Maximum auf, das bei einer Silizium-Photodiode bei ungefähr 800 nm liegt.

Die Verwendung einer derartigen Silizium-Photodiode als Detektor mit der spektralen Empfindlichkeitsverteilung des helladaptierten menschlichen Auges, das ein Maximum der Empfindlichkeit bei etwa 555 nm aufweist, erfordert zusätzlichen Aufwand, da die Wellenlängen der Empfindlichkeitsmaxima stark voneinander abweichen und die beiden spektralen Empfindlichkeitsverteilungen deshalb vergleichsweise schlecht aneinander angepasst sind. Die Anpassung der Detektorempfindlichkeit an die Empfindlichkeitsverteilung des menschlichen Auges kann durch mehrere komplexe Filter verbessert werden. In der Summe resultiert daraus die Empfindlichkeit des menschlichen Auges.

Aufgabe der Erfindung ist es daher, einen Strahlungsdetektor der eingangs genannten Art anzugeben, der möglichst einfach und kostengünstig herstellbar ist sowie eine gute Anpassung an die vorgegebene spektrale Empfindlichkeitsverteilung, insbesondere die des menschlichen Auges, aufweist.

Diese Aufgabe wird durch einen Strahlungsdetektor mit den Merkmalen des Patentanspruchs 1 gelöst. Vorteilhafte Weiterbildungen der Erfindung sind Gegenstand der abhängigen Ansprüche.

Für eine gute Anpassung ist es als im Rahmen der Erfindung ausreichend anzusehen, dass die Detektorempfindlichkeit wie im Patentanspruch 1 angegeben weitgehend der vorgegebenen Empfindlichkeit entspricht. Eine vollständige Übereinstimmung der Empfindlichkeiten ist nicht zwingend notwendig. Es soll vielmehr eine möglichst gute Anpassung an die vorgegebene Empfindlichkeit mit einem möglichst geringen Aufwand erreicht werden.

Ein Strahlungsdetektor zur Detektion von Strahlung gemäß einer vorgegebenen spektralen Empfindlichkeitsverteilung, die ein Empfindlichkeitsmaximum bei einer vorgegebenen Wellenlänge λ₀ aufweist, umfasst gemäß der vorliegenden Erfindung mindestens einen Halbleiterchip, welcher ein III-V-Halbleitermaterial enthält.

Mit Vorzug ist der Halbleiterchip bei der Erfindung ein LED-Chip, der als Strahlungsemitter zur Anwendung in einer herkömmlichen LED vorgesehen ist. Dies ermöglicht eine kostengünstige Verwirklichung des Strahlungsdetektors, da für eine Funktion als Strahlungsemitter vorgesehene LED-Chips als Halbleiterchips des Strahlungsdetektors verwendet werden können und der Aufwand zur Herstellung gezielt auf einen Strahlungsdetektor abgestimmter Halbleiterchips vermieden werden kann.

Das III-V-Halbleitermaterial umfasst bevorzugt das Funktionsmaterial des Halbleiterchips, insbesondere des LED-Chips, und/oder ist so gewählt, dass die Empfindlichkeit des Halbleiterchips in dem Bereich der vorgegebenen spektralen Empfindlichkeitsverteilung von null verschieden ist. Die Empfindlichkeit des Chips wird dabei durch die Stärke des Photostroms bestimmt, der von einer auf den Halbleiterchip einfallenden Strahlung durch Generation von Elektron-Loch-Paaren im Funktionsmaterial entsteht. Die Stromstärke des Photostroms ist von der einfallenden Strahlungsleistung und der Wellenlänge der einfallenden Strahlung abhängig und liegt typischerweise in der Größenordnung von nA. Deshalb durchläuft der Photostrom bevorzugt zum Zwecke besserer Signalverarbeitung oder -detektion einen Operationsverstärker.

Besonders bevorzugt besitzt der Halbleiterchip, insbesondere der LED-Chip, ein Maximum der Empfindlichkeit bei einer Wellenlänge λ₁, die sich möglichst wenig von der vorgegebenen Wellenlänge λ₀ unterscheidet. Die Wellenlänge λ₀ liegt vorteilhafterweise im Bereich der Emissionswellenlänge - beispielsweise der Peak- oder der Dominantwellenlänge - des LED-Chips, die dieser bei einem Betrieb als Strahlungsemitter aussenden würde.

Es sei allerdings angemerkt, dass die Wellenlänge λ₁ nicht notwendigerweise einem Maximum der Empfindlichkeit des Halbleiterchips, insbesondere des LED-Chips, entsprechen muß. Es kann vielmehr genügen, dass sie bei λ₁ einen ausreichend hohen Wert annimmt, wenn beispielsweise kein geeignetes Halbleitermaterial mit einem Empfindlichkeitsmaximum bei λ₁, das im obigen Sinne nahe genug bei λ₀ liegt, vorhanden ist.

Bevorzugt ist die Differenz der Wellenlängen λ₀ und λ₁ dem Betrag nach kleiner als 50 nm, besonders bevorzugt kleiner als 15 nm. Der Strahlungsdetektor kann somit bereits durch eine geeignete Auswahl des LED-Chips beziehungsweise des III-V-Halbleitermaterials an die vorgegebene Empfindlichkeit vorangepasst werden.

Die vorgegebene spektrale Empfindlichkeitsverteilung wird häufig so angegeben, dass sie bei der Wellenlänge λ₀ den Wert 1 beziehungsweise 100% annimmt. Die Empfindlichkeit des Halbleiterchips, insbesondere des LED-Chips, die vom Photostrom abhängt, wird häufig in Ampere pro Watt der einfallenden Strahlungsleistung angegeben.

Zum Vergleich der Detektorempfindlichkeit mit der vorgegebenen spektralen Empfindlichkeitsverteilung ist es deshalb zweckmäßig, die beiden Empfindlichkeiten so aneinander anzupassen, dass die vorgegebene Empfindlichkeit bei λ₀ und die Empfindlichkeit des Detektors bei λ₁ jeweils den Wert 100% annehmen (relative Empfindlichkeiten). Die vorliegende Beschreibung bezieht sich auf relative Empfindlichkeiten, sofern nichts anderes angegeben ist.

Bei der Erfindung ist es vorgesehen, dass zur Voranpassung der Detektorempfindlichkeit an die vorgegebene spektrale Empfindlichkeitsverteilung LED-Chips eingesetzt werden können, wie sie in handelsüblichen LEDs verwendet werden, die ein III-V-Halbleitermaterial als Funktionsmaterial besitzen. Der Aufwand und die damit verbundenen Kosten, die eine spezielle Herstellung eines neuen Halbleiterchips für einen Detektor mit sich bringt werden dadurch vorteilhaft vermieden.

Abhängig von der Wellenlänge λ₀ können beispielsweise Halbleiterchips, insbesondere LED-Chips, herangezogen werden, die InₓGa_{y}Al_{1-y}P, InₓGa_{y}Al_{1-y}N oder InₓGa_{y}Al_{1-x-y}As, jeweils mit 0≤x≤1, 0≤y≤1 und x+y≤1, als III-V-Halbleitermaterial enthalten. III-V-Halbleitermaterialien zeichnen sich durch eine vereinfacht erreichbare vorteilhaft hohe interne Quanteneffizenz aus. Insbesondere gilt dies im sichtbaren Spektralbereich, in dem die Wellenlänge λ₀ bevorzugt liegt. Für diesen Spektralbereich sind insbesondere Halbleitermaterialien aus den Materialsystemen InₓGa_{y}Al_{1-x-y}P oder InₓGa_{y}Al_{1-x-y}N besonders geeignet.

In einer bevorzugten Ausgestaltung der Erfindung ist dem Halbleiterchip, insbesondere dem LED-Chip, mindestens ein optischer Filter nachgeordnet, der die Anpassung der Detektorempfindlichkeit an die vorgegebene Empfindlichkeitsverteilung verbessert. Dies geschieht beispielsweise durch Absorption von Wellenlängen aus der einfallenden Strahlung, für die die Empfindlichkeit des Halbleiterchips, insbesondere des LED-Chips, höher als die der vorgegebenen spektralen Empfindlichkeitsverteilung ist.

Ein derartiger Filter absorbiert bevorzugt Wellenlängen, die größer als λ₀ sind, und kann zumindest teilweise innerhalb, außerhalb und/oder auf einer den Halbleiterchip, insbesondere den LED-Chip, zumindest teilweise umgebenden Umhüllung angeordnet sein. Weiterhin kann auch das Umhüllungsmaterial selbst den optischen Filter bilden oder Teil dieses Filters sein.

Der optische Filter umfasst bevorzugt eine Mehrzahl von Filterpartikeln, die besonders bevorzugt in der Umhüllung angeordnet sind und beispielsweise organische Farbstoffe enthalten.

Auch kann der optische Filter, beispielsweise in Form einer Filterfolie oder eines Filtermaterials auf der Umhüllung und/oder einer Filterstruktur außerhalb der Umhüllung vorgesehen sein.

Beispiele für Umhüllungsmaterialien sind Reaktionsharze, bevorzugt Acryl- Epoxid- oder Silikonharze oder eine Mischung aus diesen Materialien.

Derartige Materialien werden in der Halbleitertechnik oftmals zur Umhüllung Halbleiterchips, insbesondere von LED-Chips, benutzt. Bei LEDs, die als herkömmliche Strahlungsemitter ausgebildet sind, ist das Umhüllungsmaterial der LED-Chips für die emittierte Strahlung weitgehend durchlässig. Im Rahmen der Erfindung jedoch kann ein Strahlungsdetektor eine Filteranordnung der oben genannten Art umfassen, die gerade Wellenlängen absorbiert, die vom LED-Chip in der Funktion als Strahlungsemitter erzeugt würden.

Bei der Erfindung enthält der Halbleiterchip, insbesondere der LED-Chip, mindestens eine Filterschicht. Diese Filterschicht ist bevorzugt auf der Oberfläche, insbesondere einer strahlungseintrittseitigen Oberfläche, des Chips angeordnet. Mit Vorteil absorbiert die Filterschicht Wellenlängen die kleiner sind als die Wellenlänge λ₀ der vorgegebenen spektralen Empfindlichkeitsverteilung, wodurch die Anpassung der Detektorempfindlichkeit an die vorgegebene spektrale Empfindlichkeitsverteilung, insbesondere auf der kurzwelligen Seite, weitergehend verbessert wird.

Vorzugsweise ist die Filterschicht in der Form einer Passivierungs-, Deck- und/oder Schutzschicht ausgeführt, wie sie zum Beispiel bereits in handelsüblichen LED-Chips enthalten oder integriert ist. Die Filterschicht ist dabei so ausgeführt, dass einfallende Strahlung mit einer Wellenlänge die kleiner als λ₀ ist derart absorbiert wird, dass die Anpassung der Detektorempfindlichkeit an die vorgegebene spektrale Empfindlichkeitsverteilung weiter verbessert wird. Derartige Schichten weisen in der Regel eine Energielücke auf, die größer als die Energielücke der aktiven Zone des LED-Chips ist. Diese Schichten sind für die von der LED erzeugten Strahlung weitgehend durchlässig und schützen das Funktionsmaterial beispielsweise vor nachteiligen äußeren Einflüssen.

Die Filterschicht ist monolithisch im Halbleiterchip, insbesondere im LED-Chip, integriert, indem die Filterschicht, beispielsweise epitaktisch auf einem Aufwachssubstrat, zusammen mit einem Halbleiterkörper für den Halbleiterchip hergestellt wird.

Die Detektorempfindlichkeit ist dabei durch die Filterschicht bevorzugt so beeinflußt, dass bei einer beliebigen Wellenlänge kleiner als λ₀ die Differenz der Detektorempfindlichkeit und der vorgegebenen Empfindlichkeit kleiner als 25%, besonders bevorzugt kleiner als 15% ist.

Mit besonderem Vorteil muss die Detektorempfindlichkeit für Wellenlängen kleiner als λ₀ nicht mehr zusätzlich durch optische Filter, die außerhalb des Halbleiterchips, insbesondere LED-Chips, angeordnet sind, an die vorgegebene Empfindlichkeit angepasst werden. Die Anpassung kann vielmehr durch die im Halbleiterchip, insbesondere LED-Chip, enthaltene Filterschicht geschehen.

Die Filterung für Wellenlängen kleiner als λ₀ kann auch durch einen optischen Filter der oben genannten Art erreicht werden, der außerhalb des Halbleiterchips, insbesondere LED-Chips, beispielsweise in der Umhüllung angeordnet ist. Ist eine Filterschicht der oben genannten Art aber bereits im Halbleiterchip, insbesondere im LED-Chip, vorgesehen, werden der Herstellungsaufwand und die Herstellungskosten des Strahlungsdetektors vorteilhaft verringert.

Bei einer beliebigen Wellenlänge die Differenz der Detektorempfindlichkeit und der vorgegebenen Empfindlichkeit kleiner als 40%, bevorzugt kleiner als 25%. Besonders vorteilhaft ist dafür die Kombination einer Filterschicht auf dem LED-Chip oder in diesem integriert mit einem nachgeordneten optischen Filter, der oben genannten Art. Derartige Detektoren weisen verglichen mit anderen Detektoren einen geringen Platzbedarf und eine gute Anpassung an die vorgegebene spektrale Empfindlichkeitsverteilung auf.

Besonders bevorzugt ist bei einer, insbesondere beliebigen, Wellenlänge in einem Spektralbereich, der das Maximum λ₀ der vorgegebenen Empfindlichkeit enthält die Differenz der Detektorempfindlichkeit und der vorgegebenen Empfindlichkeit kleiner als 15%.

Zur Anpassung der Empfindlichkeiten kann folgendermaßen vorgegangen werden. Der LED-Chip wird zuerst so ausgewählt, dass seine Empfindlichkeit gut an die vorgegebene Empfindlichkeit vorangepasst ist.

Diese Voranpassung kann entweder bezüglich der Flanken - den Wellenlängenbereichen größer oder kleiner λ₀ - der vorgegebenen spektralen Empfindlichkeitsverteilung oder deren Maximum, beispielsweise durch die Auswahl eines geeigneten LED-Chips, geschehen.

Zur weiteren Anpassung dienen die Filter - dem LED-Chip nachgeordnete optische Filter oder Filterschichten -, die insbesondere in dem Wellenlängenbereich absorbieren, in denen der LED-Chip eine höhere Empfindlichkeit als die vorgegebene Empfindlichkeitsverteilung besitzt.

Da LED-Chips häufig im Bereich ihrer Emissionswellenlänge die höchste Empfindlichkeit aufweisen, sei angemerkt, dass solche Filter bei einer herkömmlichen LED als Strahlungsemitter die Strahlungsausbeute verringern würden. Dies gilt insbesondere für optische Filter die in der Umhüllung des LED-Chips angeordnet sind. Eine derartige Umhüllung ist somit nicht mit der Umhüllung eines herkömmlichen LED-Chips als Strahlungsemitter vergleichbar.

Bevorzugt ist die Differenz der Werte der Detektorempfindlichkeit und der vorgegebenen Empfindlichkeit bei einer vorgegebenen Wellenlänge für Empfindlichkeitswerte größer als 50 % kleiner als 25%, besonders bevorzugt kleiner als 15%.

In einer besonders bevorzugten Ausgestaltung der Erfindung ist die vorgegebene spektrale Empfindlichkeitsverteilung die des menschlichen Auges mit einem Maximum bei der Wellenlänge λ₀'. Diese Wellenlänge liegt gewöhnlich für ein helladaptiertes Auge (Tagsehen) bei ungefähr 555 nm und für ein dunkeladaptiertes Auge (Nachtsehen) bei ungefähr 500 nm.

LED-Chips mit einer Emissionswellenlänge im sichtbaren, insbesondere im roten, Spektralbereich sind für diese vorgegebene Empfindlichkeit besonders geeignet, da sie trotz ihrer roten Emissionswellenlänge eine hohe Empfindlichkeit bei den oben genannten Wellenlängen aufweisen können. Ein für die Empfindlichkeitsverteilung des helladaptierten Auges vorteilhaftes Halbleitermaterial ist InₓGa_{y}Al_{1-x-y}P, da ein auf diesem Material basierender LED-Chip je nach der genauen Zusammensetzung ein Maximum der Empfindlichkeit aufweisen kann, das im Bereich der oben angeführten Wellenlänge liegt. Durch optische Filter und Filterschichten der oben genannten Art, kann die Detektorempfindlichkeit weiter an die Augenempfindlichkeit angepasst werden.

Weiterhin kann der Strahlungsdetektor als oberflächenmontierbares Bauelement ausgebildet sein.

Erfindungsgemäße Strahlungsdetektoren werden vorzugsweise zur Steuerung und/oder Einflussnahme auf Vorrichtungen, deren Funktionsweise, Funktionszeitraum Wahrnehmung und/oder Anwendung mit der vorgegebenen spektralen Empfindlichkeitsverteilung in Verbindung steht verwendet.

Beispiele hierfür sind die Steuerung der Helligkeiten von Beleuchtungseinrichtung und Anzeigen, sowie des Ein- und/oder Ausschaltzeitpunkts von Beleuchtungseinrichtungen. Solche Beleuchtungseinrichtungen können als Innen- und Aussenraumbeleuchtungen für Wohnungen, Straßen oder Autos sowie die Hinterleuchtungseinrichtungen von Displays, wie Handydisplays, Autodisplays oder LCD-Bildschirmen realisiert sein. Für die letztgenannten Anwendungen ist ein geringer Platzbedarf des Strahlungsdetektors von besonderem Interesse.

Bei den genannten Verwendungen der Erfindung ist die vorgegebene Empfindlichkeit bevorzugt die des menschlichen Auges gegeben. Somit werden etwa die Helligkeiten der genannten Beleuchtungseinrichtungen können damit - durch Erhöhung oder Erniedrigung der Helligkeit - vorteilhaft entsprechend der Wahrnehmung durch das menschliche Auge gesteuert.

Ein weiteres Anwendungsgebiet ist die Verwendung eines derartigen Strahlungsdetektors als Umgebungslichtsensor. Die vorgegebene Empfindlichkeit ist auch hier mit Vorzug durch die des menschlichen Auges gegeben.

Weitere Merkmale, Vorteile und Zweckmäßigkeiten der Erfindung ergeben sich aus den Beschreibungen der folgenden Ausführungsbeispiele in Verbindung mit den folgenden Figuren.

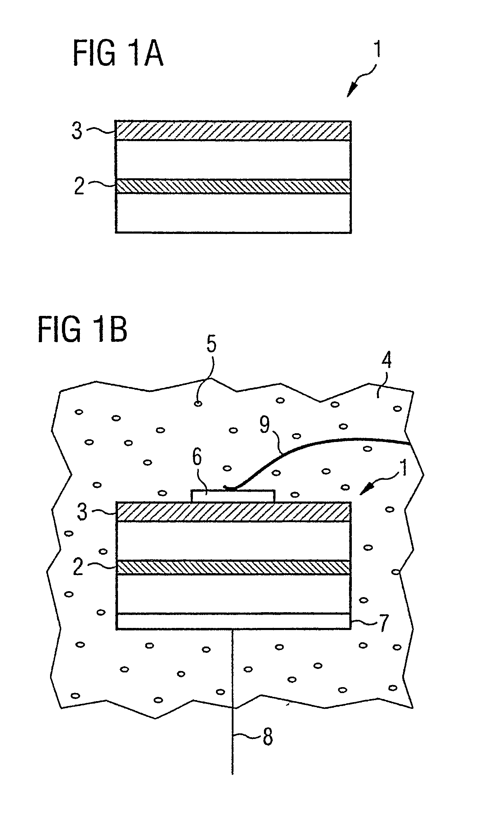

Es zeigen
- Figur 1a: und Figur 1b eine schematische Schnittansicht eines ersten Ausführungsbeispiels eines erfindungsgemäßen Strahlungsdetektors sowie eine schematische Schnittansicht eines Teiles eines zweiten Ausführungsbeispiels eines erfindungsgemäßen Strahlungsdetektors;
- Figur 2: schematisch die spektrale Verteilung der Detektorempfindlichkeiten eines dritten Ausführungsbeispiels eines Strahlungsdetektors mit verschiedenen optischen Filtern und die vorgegebene spektrale Empfindlichkeitsverteilung des menschlichen helladaptierten Auges, die bezüglich der Empfindlichkeitswerte auf die Empfindlichkeit des Chips bezogen ist;

Gleichartige und gleich wirkende Elemente besitzen in den Figuren gleiche Bezugszeichen.

In der Figur 1a ist eine schematische Schnittansicht eines LED-Chips 1 dargestellt, wie er in einem erfindungsgemäßen Strahlungsdetektor verwendet werden kann. Der Chip 1 weist eine Schicht aus einem Funktionsmaterial 2 auf, die beispielsweise das III-V-Halbleitermaterial InGaAlP enthält und von Confinementschichten begrenzt wird. Derartiges Halbleitermaterial zeichnet sich durch eine hohe Quanteneffizienz aus und wird häufig in Leuchtdioden, wie beispielsweise der Diode mit der Typenbezeichnung F 1998 A (Hersteller Osram Opto Semiconductors GmbH), benutzt. Diese LED hat eine Emissionswellenlänge im roten Spektralbereich von ungefähr 630 nm.

Der Funktionsschicht 2 ist eine Filterschicht 3 nachgeordnet, die einfallende Strahlung mit Wellenlängen, die kleiner sind als die der Energielücke der Funktionsschicht 2 entsprechenden Wellenlänge, absorbiert. Diese Filterschicht ist bei dem LED-Chip, wie er in der F 1998 A verwendet wird, bereits vorgesehen und hat in der dortigen LED in der Funktion als Strahlungsemitter beispielsweise die Funktion einer Schutz- und/oder Deckschicht, die schädlichen äußeren Einflüssen auf den LED-Chip vorbeugen kann.

Figur 1b zeigt eine schematische Schnittansicht eines Teiles eines Ausführungsbeispiels eines erfindungsgemäßen Strahlungsdetektors. Der LED-Chip 1 aus Figur 1a ist in einer Umhüllung 4 angeordnet, die ein Reaktionsharz enthält. Dieses Reaktionsharz ist bevorzugt mit organischen Farbstoffpartikeln 5 versehen, die spektrale Teilbereiche der einfallenden Strahlung absorbieren können und somit als optischer Filter wirken. Weiterhin ist der LED-Chip mit einem Bondpad 6 und einer Elektrode 7 zur elektrischen Kontaktierung des LED-Chips versehen. Über den mit der Elektrode 7 verbundenen externen elektrischen Anschluss 8 und einen mit dem Bonddraht 9 verbundenen weiteren externen Anschluss, der in der Figur 1b nicht dargestellt ist, kann ein von einer einfallenden Strahlung in der Funktionsschicht erzeugter Photostrom, eventuell über einen Operationsverstärker, gemessen werden. Die Abhängigkeit des Photostroms von der einfallenden Strahlungsleistung und der Wellenlänge der Strahlung bestimmt die Empfindlichkeit eines Strahlungsdetektors, der eine derartige Struktur mit dem LED-Chip 1, der die Filterschicht 3 aufweist, und der Umhüllung 4, in der die Farbstoffpartikel 5 angeordnet sind, umfasst.

Ein derartiger Strahlungsdetektor kann kostengünstig hergestellt werden, da LED-Chips Verwendung finden, wie sie in herkömmlichen als Strahlungsemitter ausgebildeten LEDs benutzt werden. Unterschiede zwischen diesen Detektoren und LEDs bestehen in der Beschaffenheit des Umhüllungsmaterials. Während bei LEDs das Umhüllungsmaterial für die erzeugte Strahlung durchlässig ist, kann es im Falle des Strahlungsdetektors mit dem LED-Chip erwünscht sein, dass die Umhüllung 4 mit den Filterpartikeln 5 gerade Wellenlängen aus dem Bereich, in dem der LED-Chip emittieren würde, absorbiert, um die Anpassung der Detektorempfindlichkeit an die vorgegebene Empfindlichkeit vorteilhaft zu verbessern.

Aus Figur 2 wird deutlich, wie die Detektorempfindlichkeit durch optische Filterung, beispielsweise in der Umhüllung des LED-Chips, an die spektrale Empfindlichkeitsverteilung des menschlichen Auges angepasst wird.

In der Figur 2 sind schematisch die spektralen Verteilungen der relativen Detektorempfindlichkeiten 10, 11 und 12 von Strahlungsdetektoren mit verschiedenen optischen Filtern und die vorgegebene spektrale Empfindlichkeitsverteilung 14 des menschlichen helladaptierten Auges in Abhängigkeit von der Wellenlänge λ der einfallenden Strahlung dargestellt. Die Empfindlichkeit S ist dabei in Prozent angegeben.

Die Strahlungsdetektoren enthalten jeweils einen LED-Chip, wie er beispielsweise in der LED F 1998 A (Hersteller Osram Opto Semiconductors GmbH), verwendet wird. Der LED-Chip hat eine Emissionswellenlänge im roten Spektralbereich von ungefähr 630 nm und enthält InGaAlP als Funktionsmaterial. Die dargestellten relativen Empfindlichkeitsverteilungen 10, 11 und 12 der Detektoren sind für einen Lichteinfall von der Seite der Filterschicht 3 her angegeben, die, wie in Figur 1a oder 1b dargestellt, der Funktionsschicht 2 des LED-Chips 1 nachgeordnet ist. Alle Kurvenverläufe 10, 11 und 12 der Detektorempfindlichkeiten weisen ein Empfindlichkeitsmaximum 13 bei λ₁≈560 nm auf. Die diesen Kurven entsprechenden Detektoren unterscheiden sich in den dem LED-Chip 1 nachgeordneten optische Filteranordnungen. Der der Empfindlichkeitsverteilung 10 entsprechende Detektor ist ohne eine dem LED-Chip 1 nachgeordnete Filteranordnung ausgeführt, während bei den Verteilungen 11 und 12 eine 1 mm beziehungsweise 2 mm dicke filternde Umhüllung um den LED-Chip vorgesehen ist. Die filternde Umhüllung ist beispielsweise wie in Figur 1b ein Reaktionsharz, das zum Beispiel grüne organische Farbstoffe aufweist.

Die relative spektrale Empfindlichkeitsverteilung eines helladaptierten menschlichen Auges ist bei A₀≈555 nm maximal und in der Figur 2 durch eine gepunktete Kurve 14 dargestellt. Im Zweifel kann im Rahmen der Erfindung die Augenempfindlichkeitsverteilung nach der entsprechenden DIN herangezogen werden.

Weiterhin sind in der Figur 2 Wellenlängen λₐ, λ_{b}, λ_{c}, λ_{d} und λₑ dargestellt, die verschiedene Bereiche der gezeigten Empfindlichkeitsverteilungen kennzeichnen.

Im Wellenlängenbereich zwischen ungefähr λₐ und λ₁ stimmen die Empfindlichkeiten 10, 11 und 12 schon gut mit der Augenempfindlichkeit 14 überein, was durch die Filterschicht 3 erreicht wird, die einfallende Strahlung in diesem Wellenlängenbereich absorbieren kann und dadurch die Anpassung der Detektorempfindlichkeit 10, 11, 12 an die Augenempfindlichkeit 14 vorteilhaft beeinflußt.

Die Detektor- und die Augenempfindlichkeit weichen bezüglich ihrer Wellenlängen bei einem gemeinsamen Wert der Empfindlichkeit in diesem Wellenlängenbereich bevorzugt um weniger als 30 nm besonders bevorzugt weniger als 15 nm voneinander ab.

Weiterhin ist die Differenz der Empfindlichkeitswerte der Augen- und der Detektorempfindlichkeit bei einer vorgegebenen Wellenlänge in diesem Bereich kleiner als 15%.

Für λ < λₐ allerdings fallen die Detektorempfindlichkeiten 10, 11, 12 im Gegensatz zur Augenempfindlichkeit 14 deutlich stärker ab und sind bereits für Wellenlängen kleiner als ungefähr λ_{b} zumindest nahe null. Eine Ursache dafür kann die Oberflächenrekombination von Elektron-Loch-Paaren sein, da diese Paare nicht mehr zum Photostrom beitragen können. Auch für Wellenlängen größer als ungefähr λ_{c} fallen die Detektorempfindlichkeiten stärker als die Augenempfindlichkeit ab, da die Energie der einfallenden Strahlung für Wellenlängen größer als λ_{c} nicht mehr für die Generation von Elektron-Loch-Paaren ausreicht.

Die Kurve 10 zeigt neben dem Empfindlichkeitsmaximum 13 noch weitere lokale Maxima 151 und 161. Diese liegen im Bereich um die Emissionswellenlänge des LED-Chips, die bei ungefähr 630 nm liegt. Wie der Kurve 10 zu entnehmen ist, weicht die Detektorempfindlichkeit für λ> λ₀ in ihrem gesamten Verlauf noch relativ stark - die maximale Differenz der Empfindlichkeitswerte beträgt ungefähr 70% - von der Augenempfindlichkeit ab.

Für manche Anwendungen eines derartigen Strahlungsdetektors, insbesondere für Anwendungen die auf Wellenlängen kleiner als λ₀ abzielen, kann diese Anpassung an die Augenempfindlichkeit bereits ausreichend sein. Dies ist besonders dann von Vorteil, wenn der Detektor für Anwendungen auf kleinem Raum vorgesehen ist und eine relativ dicke filternde Umhüllung die Bauteilgröße nachteilig erhöht.

Eine derartige Anpassung kann, wie oben ausgeführt, bereits durch die geeignete Auswahl des Halbleitermaterials, beziehungsweise des LED-Chips, erreicht werden.

Um die Anpassung der Detektorempfindlichkeit an die Augenempfindlichkeit zu verbessern, ist bei den den Kurven 11 und 12 entsprechenden Detektoren eine Umhüllung vorgesehen, die aus der einfallenden Strahlung Wellenlängen größer als 555 nm - insbesondere im roten Spektralbereich des lokalen Maximums 151 bei ungefähr 630 nm - absorbiert.

Die Dicke der Umhüllung bestimmt die in ihr absorbierte Strahlungsleistung der einfallenden Strahlung und damit den erzeugten Photostrom und die Detektorempfindlichkeit.

Verglichen mit der Detektorempfindlichkeit 10 wird die Anpassung an die Augenempfindlichkeit 14 durch eine 1 mm dicke grüne Umhüllung wie der dargestellten Detektorempfindlichkeit 11 entnommen werden kann, weiter deutlich verbessert. Das lokale Maximum 151 der Kurve 10 entspricht der Schulter 152 in der Kurve 11 und ist durch die Absorption in der Umhüllung stark abgeflacht. Das lokale Maximum 161 ist in Form des Maximums 162, das wegen der Absorption in der Umhüllung einen geringeren Empfindlichkeitswert als das lokale Maximum 161 besitzt, noch vorhanden.

Wird eine 2 mm dicke grüne Umhüllung vorgesehen, ist die Anpassung der entsprechenden Detektorempfindlichkeit 12 an die Augenempfindlichkeit 14 wegen der höheren absorbierten Strahlungsleistung noch weiter verbessert. Auch hier bleibt das lokale Maximum 162 in Form des Maximums 163 erhalten. Das ursprüngliche Maximum 151 ist bei 153 so stark abgeflacht, dass es nicht mehr erkennbar ist.

Bei einer vorgegebenen Wellenlänge ist hierbei die Differenz der entsprechenden Detektor- und Augenempfindlichkeitswerte kleiner als 25%.

Für Werte der Empfindlichkeit S - größer als ungefähr 50% - ist der Detektor sehr gut an die Augenempfindlichkeit angepasst und die Differenz der Detektor- und der Augempfindlichkeitswerte kleiner als ungefähr 10%. Eine derartige Anpassung an die Augenempfindlichkeit kann für Anwendungen ausreichend sein, da dies gerade der Bereich ist, in dem das Auge am empfindlichsten ist.

Zwischen ungefähr λₑ und λ_{c} weicht die Detektorempfindlichkeit 12 noch relativ stark von der Augenempfindlichkeit 14 ab. Würde im Strahlungsdetektor eine weitere Filteranordnung vorgesehen, die im Bereich der dem lokalen Maximum 163, 162 oder 161 entsprechenden Wellenlänge absorbiert, kann die Anpassung an die Augenempfindlichkeit 13 in diesem Bereich gegebenenfalls noch weiter verbessert werden.

## Patentansprüche

1. Strahlungsdetektor, der mindestens einen Halbleiterchip (1) umfasst, der mindestens ein III-V-Halbleitermaterial enthält, wobei
der Strahlungsdetektor ein Strahlungsdetektor zur Detektion von Strahlung gemäß der spektralen Empfindlichkeitsverteilung (14) des menschlichen Auges ist, die ein Empfindlichkeitsmaximum bei einer Wellenlänge λ₀ aufweist und bei λ₀ den Wert 100% annimmt, und eine Detektorempfindlichkeit (12) aufweist, **dadurch gekennzeichnet, dass** der Halbleiterchip (1) eine Filterschicht (3) aufweist, die im Halbleiterchip integriert ist und wobei die Filterschicht (3) Wellenlängen absorbiert, die kleiner als λ₀ sind, und wobei der Filterschicht die Detektorempfindlichkeit so beeinflusst, dass bei einer jeden, Wellenlänge zwischen 400 nm und 800 nm und kleiner λ₀ die Differenz der entsprechenden Werte der Detektorempfindlichkeit (12) und der spektralen Empfindlichkeitsverteilung (14) des menschlichen Auges kleiner als 25% ist.

2. Strahlungsdetektor nach Anspruch 1,
**dadurch gekennzeichnet, dass**
der Strahlungsdetektor mindestens einen dem Halbleiterchip (1) nachgeordneten optischen Filter umfasst und der optische Filter Strahlung mit einer Wellenlänge absorbiert die größer als die Wellenlänge λ₀ des Empfindlichkeitsmaximums des menschlichen Auges ist.

3. Strahlungsdetektor nach einem der vorhergehenden Ansprüche,
**dadurch gekennzeichnet, dass**
der Halbleiterchip ein LED-Chip ist.

4. Strahlungsdetektor nach einem der vorhergehenden Ansprüche,
**dadurch gekennzeichnet, dass**
die Empfindlichkeit des Halbleiterchips (1) mindestens ein Maximum (13) bei einer Wellenlänge λ₁ aufweist, wobei diese Wellenlänge um nicht mehr als 50 nm, bevorzugt nicht mehr als 15 nm, von der Wellenlänge λ₀ abweicht.

5. Strahlungsdetektor nach einem der vorhergehenden Ansprüche,
**dadurch gekennzeichnet, dass**
der Detektor eine Umhüllung (4) aufweist, die den Halbleiterchip (1) zumindest teilweise umgibt.

6. Strahlungsdetektor nach Anspruch 5,
**dadurch gekennzeichnet, dass**
die Umhüllung (4) ein Harz, vorzugsweise ein Reaktionsharz, enthält.

7. Strahlungsdetektor nach Anspruch 5 oder 6 unter Rückbezug auf Anspruch 2 oder einen auf diesen Anspruch rückbezogenen Anspruch,
**dadurch gekennzeichnet, dass**
der optische Filter zumindest teilweise innerhalb, außerhalb und/oder auf der Umhüllung (4) angeordnet ist und/oder das Umhüllungsmaterial selbst den Filter bildet.

8. Strahlungsdetektor nach einem der Ansprüche 2 bis 7,
**dadurch gekennzeichnet, dass**
der optische Filter eine Mehrzahl von Filterpartikeln (5) umfasst.

9. Strahlungsdetektor nach einem der vorhergehenden Ansprüche,
**dadurch gekennzeichnet, dass**
bei einer jeden Wellenlänge zwischen 400 nm und 800 nm die Differenz der entsprechenden Werte der Detektorempfindlichkeit (12) und der spektralen Empfindlichkeitsverteilung (14) des menschlichen Auges kleiner als 25% ist.

10. Strahlungsdetektor nach einem der vorhergehenden Ansprüche,
**dadurch gekennzeichnet, dass**
das III-V-Halbleitermaterial InₓGa_{y}Al_{1-x-y}P oder InₓGa_{y}Al_{1-x-y}N, jeweils mit 0≤x≤1, 0≤y≤1 und x+y≤1, ist.

11. Strahlungsdetektor nach Anspruch 10,
**dadurch gekennzeichnet, dass**
das III-V-Halbleitermaterial InGaAlP ist.

12. Strahlungsdetektor nach einem der Ansprüche 3 bis 11,
**dadurch gekennzeichnet, dass**
die Emissionswellenlänge des LED-Chips (1) im roten Spektralbereich liegt.

13. Verwendung eines Strahlungsdetektors nach einem der vorhergehenden Ansprüche
als
Umgebungslichtsensor.

14. Verwendung eines Strahlungsdetektors nach einem der vorhergehenden Ansprüche
zur
Steuerung einer Einflussnahme auf Vorrichtungen, deren Funktionsweise, Funktionszeitraum, Wahrnehmung und/oder Anwendung mit der spektralen Empfindlichkeitsverteilung des menschlichen Auges in Verbindung steht.

15. Verwendung eines Strahlungsdetektors nach einem der vorhergehenden Ansprüche
zur
Steuerung der Helligkeit von Beleuchtungseinrichtungen.

16. Verwendung eines Strahlungsdetektors nach einem der vorhergehenden Ansprüche
zur
Steuerung der Helligkeit der Hinterleuchtung von LCD-Bildschirmen.

17. Verwendung eines Strahlungsdetektors nach einem der vorhergehenden Ansprüche
zur
Steuerung der Helligkeit von Anzeigen.

18. Verwendung eines Strahlungsdetektors nach einem der vorhergehenden Ansprüche
zur
Steuerung des Ein- oder Ausschaltzeitpunkts von Beleuchtungseinrichtungen.

## Claims

1. Radiation detector comprising at least one semiconductor chip (1) containing at least one III-V semiconductor material, wherein
the radiation detector is a radiation detector for detecting radiation in accordance with the spectral sensitivity distribution (14) of the human eye, having a sensitivity maximum at a wavelength λ₀ and reaching the value 100% at λ₀, and has a detector sensitivity (12), **characterized in that** the semiconductor chip (1) has a filter layer (3) integrated in the semiconductor chip, and wherein the filter layer (3) absorbs wavelengths which are less than λ₀, and wherein the filter layer influences the detector sensitivity such that, at any wavelength between 400 nm and 800 nm and less than λ₀, the difference between the corresponding values of the detector sensitivity (12) and the spectral sensitivity distribution (14) of the human eye is less than 25%.

2. Radiation detector according to Claim 1,
**characterized in that**
the radiation detector comprises at least one optical filter disposed downstream of the semiconductor chip (1), and the optical filter absorbs radiation having a wavelength that is greater than the wavelength λ₀ of the sensitivity maximum of the human eye.

3. Radiation detector according to either of the preceding claims,
**characterized in that**
the semiconductor chip is an LED chip.

4. Radiation detector according to any of the preceding claims,
**characterized in that**
the sensitivity of the semiconductor chip (1) has at least one maximum (13) at a wavelength λ₁, wherein said wavelength deviates from the wavelength λ₀ by not more than 50 nm, preferably not more than 15 nm.

5. Radiation detector according to any of the preceding claims,
**characterized in that**
the detector has an encapsulation (4), which at least partly surrounds the semiconductor chip (1).

6. Radiation detector according to Claim 5,
**characterized in that**
the encapsulation (4) contains a resin, preferably a reaction resin.

7. Radiation detector according to Claim 5 or 6 referring back to Claim 2 or any claim referring back to said claim,
**characterized in that**
the optical filter is arranged at least partly within, outside and/or on the encapsulation (4) and/or the encapsulation material itself forms the filter.

8. Radiation detector according to any of Claims 2 to 7,
**characterized in that**
the optical filter comprises a plurality of filter particles (5).

9. Radiation detector according to any of the preceding claims,
**characterized in that**
at any wavelength between 400 nm and 800 nm, the difference between the corresponding values of the detector sensitivity (12) and the spectral sensitivity distribution (14) of the human eye is less than 25%.

10. Radiation detector according to any of the preceding claims,
**characterized in that**
the III-V semiconductor material is InₓGa_{y}Al_{1-x-y}P or InₓGa_{y}A_{l-x-y}N, in each case where 0 ≤ x ≤ 1, 0 ≤ y ≤ 1 and x+y ≤ 1.

11. Radiation detector according to Claim 10,
**characterized in that**
the III-V semiconductor material is InGaAlP.

12. Radiation detector according to any of Claims 3 to 11,
**characterized in that**
the emission wavelength of the LED chip (1) is in the red spectral range.

13. Use of a radiation detector according to any of the preceding claims
as
an ambient light sensor.

14. Use of a radiation detector according to any of the preceding claims
for
controlling an influencing of devices whose functioning, functional time period, perception and/or application is linked to the spectral sensitivity distribution of the human eye.

15. Use of a radiation detector according to any of the preceding claims
for
controlling the brightness of lighting devices.

16. Use of a radiation detector according to any of the preceding claims
for
controlling the brightness of the backlighting of LCD screens.

17. Use of a radiation detector according to any of the preceding claims
for
controlling the brightness of displays.

18. Use of a radiation detector according to any of the preceding claims
for
controlling the switch-on or switch-off instant of lighting devices.

## Revendications

1. Détecteur de rayonnement comprenant au moins une puce à semi-conducteur (1) qui contient au moins un matériau semi-conducteur III-V, dans lequel
le détecteur de rayonnement est un détecteur de rayonnement destiné à détecter un rayonnement conformément à la distribution de sensibilité spectrale (14) de l'oeil humain, qui présente un maximum de sensibilité à une longueur d'onde λ₀ et atteint une valeur de 100 % à λ₀, et présente une sensibilité de détecteur (12), **caractérisé en ce que** la puce à semi-conducteur (1) présente une couche de filtrage (3) qui est intégrée à la puce à semi-conducteur, et dans lequel la couche de filtrage (3) absorbe des longueurs d'onde qui sont inférieures à λ₀ et dans lequel la couche de filtrage influence la sensibilité de détecteur de telle manière qu'à chacune de longueurs d'onde comprises entre 400 et 800 nm et inférieures à λ_{0,} la différence entre les valeurs correspondantes de la sensibilité de détecteur (12) et la distribution de sensibilité spectrale (14) de l'oeil humain soit inférieure à 25 %.

2. Détecteur de rayonnement selon la revendication 1, **caractérisé en ce que** le détecteur de rayonnement comprend au moins un filtre optique disposé en aval de la puce à semi-conducteur (1) et **en ce que** le filtre optique absorbe un rayonnement ayant une longueur d'onde supérieure à la longueur d'onde λ₀ du maximum de sensibilité de l'oeil humain.

3. Détecteur de rayonnement selon l'une quelconque des revendications précédentes, **caractérisé en ce que** la puce à semi-conducteur est une puce à LED.

4. Détecteur de rayonnement selon l'une quelconque des revendications précédentes, **caractérisé en ce que** la sensibilité de la puce à semi-conducteur (1) présente au moins un maximum (13) à une longueur d'onde λ₁, ladite longueur d'onde ne déviant pas de plus de 50 nm, et de préférence de plus de 15 nm, de la longueur d'onde λ₀.

5. Détecteur de rayonnement selon l'une quelconque des revendications précédentes, **caractérisé en ce que** le détecteur présente une enveloppe (4) qui entoure au moins partiellement la puce à semi-conducteur (1).

6. Détecteur de rayonnement selon la revendication 5, **caractérisé en ce que** l'enveloppe (4) contient une résine, de préférence une résine réactionnelle.

7. Détecteur de rayonnement selon la revendication 5 ou 6 lorsqu'elle se réfère à la revendication 2 ou selon une revendication se référant à ladite revendication, **caractérisé en ce que** le filtre optique est disposé au moins en partie à l'intérieur, à l'extérieur et/ou sur l'enveloppe (4) et/ou **en ce que** le matériau de l'enveloppe forme lui-même le filtre.

8. Détecteur de rayonnement selon l'une quelconque des revendications 2 à 7, **caractérisé en ce que** le filtre optique comprend une pluralité de particules de filtrage (5).

9. Détecteur de rayonnement selon l'une quelconque des revendications précédentes, **caractérisé en ce que**, à chaque longueur d'onde comprise entre 400 nm et 800 nm, la différence entre les valeurs correspondantes de la sensibilité de détecteur (12) et de la distribution de sensibilité spectrale (14) de l'oeil humain est inférieure à 25 %.

10. Détecteur de rayonnement selon l'une quelconque des revendications précédentes, **caractérisé en ce que** le matériau semi-conducteur III-V est l'InₓGa_{y}Al_{1-x-y}P ou l'InₓGa_{y}Al_{1-x-y}N, avec dans chaque cas 0≤x≤1, 0≤y≤1 et x+y≤1.

11. Détecteur de rayonnement selon la revendication 10, **caractérisé en ce que** le matériau semi-conducteur III-V est l'InGaAlP.

12. Détecteur de rayonnement selon l'une quelconque des revendications 3 à 11, **caractérisé en ce que** la longueur d'onde d'émission de la puce à LED (1) se situe dans la région spectrale rouge.

13. Utilisation d'un détecteur de rayonnement selon l'une quelconque des revendications précédentes en tant que capteur de lumière ambiante.

14. Utilisation d'un détecteur de rayonnement selon l'une quelconque des revendications précédentes pour commander un effet sur des dispositifs dont le mode de fonctionnement, l'intervalle de temps de fonctionnement, la perception et/ou l'emploi sont liés à la distribution de sensibilité spectrale de l'oeil humain.

15. Utilisation d'un détecteur de rayonnement selon l'une quelconque des revendications précédentes pour commander la luminosité de dispositifs d'éclairage.

16. Utilisation d'un détecteur de rayonnement selon l'une quelconque des revendications précédentes pour commander la luminosité du rétroéclairage d'écrans à cristaux liquides.

17. Utilisation d'un détecteur de rayonnement selon l'une quelconque des revendications précédentes pour commander la luminosité d'afficheurs.

18. Utilisation d'un détecteur de rayonnement selon l'une quelconque des revendications précédentes pour commander l'instant d'allumage ou d'extinction de dispositifs d'éclairage.
